Europäisches Patentamt

European Patent Office

Office européen des brevets

(11) Publication number: **0 139 517**
**B1**

(12) EUROPEAN PATENT SPECIFICATION

(45) Date of publication of patent specification: **03.01.90**

(51) Int. Cl.⁵: **H 05 K 7/20, H 01 L 23/36**

(21) Application number: **84307061.6**

(22) Date of filing: **16.10.84**

(54) Improvements in or relating to diamond heatsink assemblies.

(30) Priority: **26.10.83 GB 8328573**

(43) Date of publication of application:
**02.05.85 Bulletin 85/18**

(45) Publication of the grant of the patent:
**03.01.90 Bulletin 90/01**

(84) Designated Contracting States:
**DE FR IT NL**

(56) References cited:
**EP-A-0 019 003**
**US-A-3 828 848**

(73) Proprietor: **PLESSEY OVERSEAS LIMITED**
**Vicarage Lane**
**Ilford Essex IG1 4AQ (GB)**

(72) Inventor: **Eaton, Ralph Melville**
**21 Mapperley Drive**
**Northampton (GB)**
Inventor: **Geen, Michael William**
**93 Watermeadow Drive**
**Northampton NN3 4ST (GB)**

(74) Representative: **Field, Howard John**
**The Plessey Company plc Beeston**
**Nottingham, NG9 1LA (GB)**

Courier Press, Leamington Spa, England.

## Description

This invention relates to diamond heatsink assemblies, particularly those that are suitable for mounting thereon small electronic devices which emit a fair degree of heat when in operation.

It is known to provide a diamond as a heatsink for such devices since the thermal conductivity of a diamond mounted on a suitable metal heatsink mounting of high thermal conductivity is at least twice that of the metal heatsink mounting alone. The metal heatsink mounting usually comprises a threaded stud of gold, silver or copper with the diamond pressed into the end or the diamond may be mounted on top of the stud by soldering, brazing or welding. The stud is adapted to be screwed into a base or wall member until the end of the stud is substantially aligned with the surface of the base or wall member with the electronic device mounted centrally on the diamond. The electronic device may, for example project into a waveguide.

One problem with this arrangement is that if the electronic device becomes faulty the threaded stud must be removed and the assembly completed replaced.

Hitherto it has been common practice to mount an electronic device upon the top flat polished surface of a diamond. Thus in United States Patent No. 3,828,848 a diamond is disclosed which is of essentially spheroidal shape but which is truncated to provide a flat polished mounting surface. Optionally, the lower portion of this spheroidal diamond too may be polished flat, but this is embedded below the surface of the metal stud mounting into which this diamond is pressed or affixed. Also, in European Patent Application No. 0,019,003 an electronic device is mounted upon the top flat polished surface of a cuboid metal-coated diamond. This coating is of chromium and platinum layered structure. Electrical contact between the electronic device and metal-coated diamond is said to be much improved by the application of vacuum evaporated gold-tin alloy to the exposed metal-coating and metal mounting upon which the diamond is affixed.

It is an object of the present invention to provide a diamond heatsink assembly which will overcome problems of device replacement or multiple mounting.

According to the present invention a diamond heatsink assembly comprises a metal-coated diamond secured relative to, and in thermal and electrical contact with, a metal heatsink mounting, and having upon its surface an electronic device; characterised in that the diamond is multifaceted having thus a top facet, and a plurality of angled facets, which angled facets are exposed above and inclined at an angle to the heatsink mounting, and are lapped or polished flat and of sufficient surface area each to support separately the electronic device, this electronic device being mounted upon one of these angled facets.

The diamond may be partially embedded in the metal heatsink mounting by pressing, soldering or clamping. Alternatively, the metal heatsink mounting may comprise a split collet arrangement whereby the diamond is readily removable.

Preferably the metallic coating of the diamond forms the bias bonding stud/R.F. circuit connection for the electronic device. To minimise parasitic impedances and to provide a minimal size R.F. circuit contact, at least one break may be left across the metallic coating of the diamond to eliminate the need for insulating rings or stand-offs.

Embodiments of the invention will now be described by way of example only with reference to the accompanying drawings in which

Figure 1 is a perspective view of a diamond heatsink assembly according to the invention;

Figure 2 is a cross-sectional view through the assembly illustrated in Figure 1;

Figure 3, 4 and 5 show modified versions of the assembly; and,

Figure 6 shows a multi-faceted diamond supported in a split-collet arrangment.

A semiconductor device *c* is mounted on a polished or lapped facet *h* of a metallised Type IIA diamond, *a*, which is large enough to allow the dissipated heat to spread to a larger area before reaching a metal heatsink *b*. The diamond *a* has a metallised top facet *d*, parallel to the heatsink face, whilst the semiconductor device *c* lies between this top facet *d* and the heatsink *b* so that RF circuit contact may be made to the semiconductor device *c* through top facet *d* and bond wire(s) or tape(s) *e*, without directly touching the semiconductor device *c*, thereby providing some mechanical protection to the device *c* as well as excellent heatsinking. A d.c. break *f* is provided in the metallisation for necessary isolation.

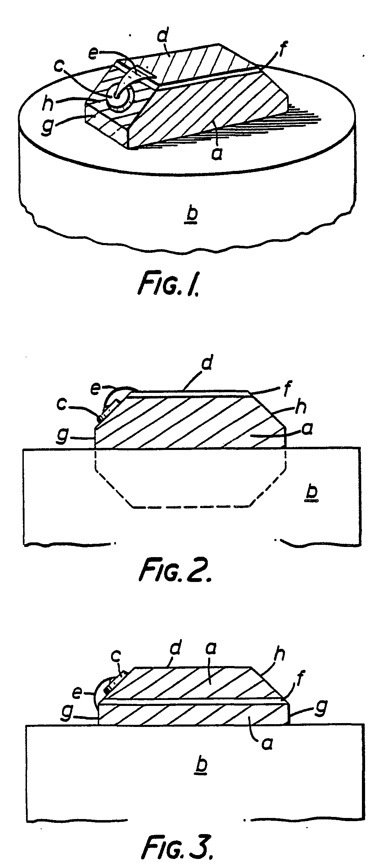

The d.c. break *f* may be above the semiconductor device *c*, as in Figure 1, or below it as in Figure 3 (thereby effectively inverting the polarity of the device *c*). In either case the d.c. break *f* is traversed by the bond-wire or tape *e*. The wire or tape *e* may be bonded from the top of the semiconductor device *c* to a side facet *g*, another angled facet *h*, or the top facet *d* (as in Figure 1) of the diamond *a* or to the metal heatsink *b* itself.

The metallised diamond *a* is pressed, soldered, welded or clamped into the heatsink *b*.

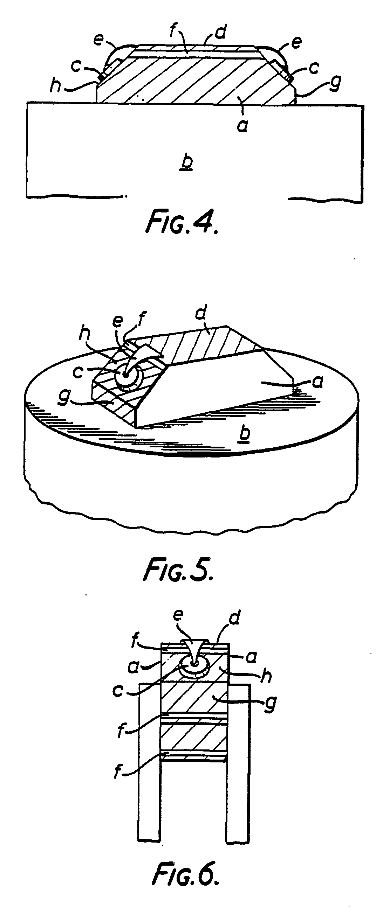

Two or more devices *c* may be mounted together on the diamond *a* as shown in Figure 4. These may be interconnected in series or in parallel (as shown), or in a combination or series and parallel.

The package described allows the use of low parasitic impedances because of short length bond-wires *e* providing an inductance of typically 20—30 pH and a controllable shunt capacitance by adjusting the height and area of the top metallised facet *d*. The capacitance can be as low as 0.01 pF, see Figure 5. The respective impedances for a quartz stand-off or ring arrangement are no better than 0.1 pF and 30—40 pH. The package permits easier circuit matching because it launches into a single well-defined central contact *d*, unlike the distributed contact that would otherwise be formed by quartz or ceramic rings or stand-offs which would stand outside the device *c*. This package therefore should be suitable for use with higher power millimetric-wave devices of small area.

The diamond *a* shown in Figures 1 to 4 is typically of octagonal cross section with two large parallel facets top and bottom. The principle described however may be applied to other shaped, e.g. hexagonal or any convenient shape with a top facet and lapped or polished flat angled facets onto which semiconductor devices *c* may be mounted.

The metallisation is shown all over except for the d.c. break *f*. It is possible, however to reduce capacitance by using a "skeleton" or minimum or metallisation as shown in Figure 5.

Because of the high cost of diamond heatsink packages and the high hazard rate for millimetric wave devices, the multi-facet facility of this package also allows the re-use of the packages for a replacement semiconductor device *c* when the one device *c* has failed, thereby providing substantial cost saving over conventional diamond heatsink arrangements.

Figure 6 illustrates an arrangement wherein the type IIA diamond *a* acts at the microwave package in its entirety. A multi-faceted diamond *a*, each angled facet *h* a potential site for device bonding, is held rigidly for component bonding. As an example, Figure 6 shows a 6-sided diamond *a* clamped in a split-collet arrangement.

A similar arrangement is envisaged to hold the diamond *a* in position in a waveguide. In common with Figures 1 to 5, stand-offs would not be necessary; the electrical d.c. isolation requirements being satisfied by breaks *f* in the diamond metallisation. In the event of device failure, the diamond *a* could be removed easily from the reusable clamping structure, the device *c* removed and a new one *c* secured to another angled facet *h*.

**Claims**

1. A diamond heatsink assembly comprising a metal-coated diamond (a) secured relative to, and in thermal and electrical contact with, a metal heatsink mounting (b), and having upon its surface an electronic device (c); characterised in that:

the diamond (a) is multifaceted having thus a top facet (d), and a plurality of angled facets (h), which angled facets (h) are exposed above and inclined at an angle to the heatsink mounting (b), and are lapped or polished flat and of sufficient surface area each to support separately the electronic device (c), this electronic device (c) being mounted upon one of these angled facets (h).

2. An assembly, as claimed in claim 1, further characterised by:

a break (f) in the continuity of the metal-coating of the diamond, which break (f) provides electrical d.c. isolation between the one angled facet (c) and a second facet (d; g) of the metal-coated diamond (a); and,

an electrical connection (e) which extends from the electronic device (c) to said second facet (d; g) of the metal-coated diamond (a).

3. An assembly (figure 2), as claimed in claim 2, wherein said second facet (d) is the top facet (d) of the metal-coated diamond (a).

4. An assembly (figure 3), as claimed in claim 2, wherein the diamond has a plurality of side facets (g) also exposed above the heatsink mounting (b), said second facet (g) being one of these (g).

5. An assembly, as claimed in any one of the preceding claims, wherein the diamond (a) is of octagonal cross-section for a section (figure 2) taken through the one angled facet (h).

6. An assembly (figure 4), as claimed in any one of the preceding claims, wherein the electronic device (c) is interconnected to a second electronic device (c) which latter is mounted upon a second one of the angled facets (h).

**Patentansprüche**

1. Ein Diamantenkühlkörperbausatz, bestehend aus einem metallbeschichteten Diamanten (a), befestigt an und in thermischem und elektrischen Kontakt mit einer Kühlkörperhalterung aus Metall (b) und mit einem elektronischen Gerät auf der Oberfläche; gekennzeichnet dadurch, daß:

der Diamant (a) mehrere Facetten aufweist, d.h. eine Oberfacette (h) und eine Mehrzahl gewinkelter Facetten (h), wobei die gewinkelten Facetten (h) über der Kühlkörperhalterung exponiert sind und in einem Winkel relativ zur Kühlkörperhalterung (b) schräg stehen, weiters gelappt oder flach poliert sind und jeweils eine so große Oberfläch aufweisen, um das elektronische Gerät (c) zu tragen. Hierbei ist das elektronische Gerät auf einer dieser gewinkelten Facetten (h) montiert.

2. Ein Bausatz wie in Anspruch 1, weiters dadurch gekennzeichnet, daß:

die Kontinuität der Metallbeschichtung unterbrochen (Bruch, f) ist, wobei durch besagten Bruch (f) eine elektrische Gleichstomisolierung zwischen der gewinkelten Facette (c) und einer zweiten Facette (d; g) des metallbeschichteten Diamanten (a) bewirkt wird; weiters einen elektrischen Anschluß (e) an die besagte zweite Facette (d; g) des metallbeschichteten Diamanten (a).

3. Ein Bausatz (Abbildung 2) wie in Anspruch 2, wobei die besagte zweite Facette (d) die Oberfacette (d) des metallbeschichteten Diamanten (a) ist.

4. Ein Bausatz (Abbildung 3) wie in Anspruch 2, wobei der Diamant eine Mehrzahl von Seitenfacetten (g) aufweist, die auch über der Kühlkörperhalterung (b) exponiert sind und die besagte zweite Facette (g) eine dieser Facetten (g) ist.

5. Ein Bausatz wie in einem der Vorherigen Ansprüche, wobei der Diamant (a) einen achtseitigen Querschnitt für einen Schnitt (Abbildung 2), der durch die eine gewinkelte Facette (h) verläuft, aufweist.

6. Ein Bausatz (Abbildung 4) wie in einem der vorherigen Ansprüche, wobei das elektronische Gerät (c) mit einem zweiten elektronischen Gerät (c) verbunden ist, wobei letzteres auf einer zweiten gewinkelten Facette (h) montiert ist.

**Revendications**

1. Ensemble à radiateur de diamant comprenant un diamant (a) revêtu d'un métal et fixé à un organe métallique (b) de montage en étant en contact thermique et électrique avec celui-ci, et portant un dispositif électronique (c) à sa surface, caractérisé en ce que le diamant (a) a plusieurs facettes comprenant ainsi une facette supérieure (d) et plusieurs facettes inclinées (h), les facettes inclinées (h) étant exposées par-dessus, étant inclinées par rapport à l'organe (b) de montage de radiateur, étant rodées ou polies à plat et ayant une étendue suffisante pour qu'elles puissent supporter chacune séparément le dispositif électronique (c), ce dispositif électronique (c) étant monté sur l'une des facettes inclinées (h).

2. Ensemble selon la revendication 1, caractérisé en outre par une séparation (f) formée dans la continuité du revêtement métallique du diamant, cette séparation (f) assurant l'isolement électrique en courant continu entre ladite facette inclinée (c) et une seconde facette (d; g) du diamant (a) revêtu d'un métal, et une connexion électrique (e) allant du dispositif électronique (c) à la seconde facette (d; g) du diamant (a) revêtu de métal.

3. Ensemble (figure 2) selon la revendication 2, dans lequel la seconde facette (d) est la facette supérieure (d) du diament (a) revêtu de métal.

4. Ensemble (figure 3) selon la revendication 2, dans lequel le diamant a plusieurs facettes latérales (g) qui sont aussi exposées au-dessus de l'organe (b) de montage de radiateur, la seconde facette (g) étant l'une de ces facettes latérales (g).

5. Ensemble seln l'une quelconque des revendications précédentes, dans lequel le diamant (a) a une section octagonale dans un plan de coupe (figure 2) traversant la première facette inclinée (h).

6. Ensemble (figure 4) selon l'une quelconque des revendications précédentes, dans lequel le dispositif électronique (c) est interconnecté à un second dispositif électronique (c), ce dernier étant monté sur une seconde facette inclinée (h).

Fig. 1.

Fig. 2.

Fig. 3.

1

FIG.4.

FIG.5.

FIG.6.